# EUROPEAN PATENT SPECIFICATION

(11) **EP 3 678 156 B1**
(45) Date of publication and mention of the grant of the patent: **01.03.2023**
(21) Application number: 18878502.6
(22) Date of filing: 24.10.2018
(51) Int. Cl.: H01H 13/705, H01H 13/85

(54) **MAGNETIC-TYPE BUTTON**
MAGNETKNOPF
BOUTON DE TYPE MAGNÉTIQUE

(30) Priority: 16.11.2017 CN 201711138848
(43) Date of publication of application: 08.07.2020
(73) Proprietor: DONGGUAN HEATMOVING ELECTRONIC TECHNOLOGY CO., LTD., Dongcheng Street Dongcheng Guangdong 523000 (CN)
(72) Inventor: LIU, Lucy, Dongguan, Guangdong 523000 (CN); LI, Andong, Dongguan, Guangdong 523000 (CN)
(74) Representative: Heinonen & Co
(86) International application number: PCT/CN2018/111672
(87) International publication number: WO 2019/095949

(56) References cited:
- CN-A- 107 195 501
- CN-A- 107 785 202
- CN-U- 207 458 812
- JP-A- H0 237 627
- JP-A- H0 546 296
- JP-A- H09 212 273
- JP-A- H11 339 590
- US-B2- 6 962 452

## Description

### Technical Field

The present disclosure relates to a magnetic key (magnetic-type button) offering an adjustable tactile feel, and in particular to a key offering an adjustable tactile intensity.

### Background Art

A keyboard is the most common and important input device for a computer. By typing on the keyboard, English letters, numbers, punctuation marks, and the like can be input into the computer so as to issue commands and input data or the like to the computer. The keyboards are divided into mechanical keyboards, thin-film keyboards, conductive silicone keyboards, and capacitive keyboards, wherein the mechanical keyboards are very popular with gamers because it can achieve a strong sense of rhythm and an unchangeable keystroke feel even during long-term use.

At present, the tactile feel and pressure from the mechanical keyboards is changed mainly by using different shafts and spring element structures, such as the four shafts which are black, red, blue, and brown shafts commonly available in the market. The black shaft offers the strongest tactile feel; the red shaft offers substantially no tactile feel; the blue shaft offers a weak tactile feel, but offers a distinct clicky feel, with a clear rhythmic sound; and the brown shaft offers a similar tactile feel to the blue shaft, but does not offer a distinct clicky feel. If a user wants to feel different during keystrokes, the user must buy mechanical keyboards with shafts of different colors. If the user does not know their own preferences, the user may be likely to buy mechanical keyboards that are not suitable for himself/herself, which will cause the user to repeatedly buy the keyboards and thus waste costs. It is also impossible to define the tactile feel and force for a mechanical shaft according to the user's own personal preference.

An electronically adjustable magnetic key switch, such as a push button key switch for keyboards, is disclosed in JP H11 339590 A. The key switch comprises a shaft arranged below a button top portion and supporting a number of magnets with electromagnetic coils and a push-back spring. The pressure required to press the key switch is regulated by virtue of adjusting the current flow through the coils.

### Summary

An object of the present disclosure is to solve the above defects and to provide a magnetic key, in which a tactile intensity from a mechanical shaft is changed by controlling an electric current of a coil to change an impact force from a magnet.

The object of the present disclosure is achieved by following solutions.

A magnetic key comprises a housing and a central shaft body provided in the housing, wherein a keycap seat is provided on the top of the central shaft body, the bottom of the central shaft body extends into the housing, and the central shaft body can be reciprocated in a base along a vertical direction when the keycap seat is pressed, wherein the central shaft body is provided with a stop plate partitioning the central shaft body into two sections, a first magnetic element is provided on the upper section of the central shaft body, a second magnetic element movable up and down is provided coaxially with and below the first magnetic element, the second magnetic element is provided on the upper section of the central shaft body, a return spring is provided on the lower section of the central shaft body, a third magnetic element is provided in the housing, and the third magnetic element is a coil able of being energized with adjustable current or an electromagnet.

In the above description, in a more preferred solution, when the energizable coil is not energized or is energized in a reverse direction, a magnetic force is generated between the first magnetic element and the second magnetic element or a repulsive force is generated between the second magnetic element and the third magnetic element, such that the second magnetic element is held on the upper section of the central shaft body; when the energizable coil is energized in a forward direction, a magnetic force is generated between the second magnetic element and the third magnetic element and is greater than the magnetic force between the first magnetic element and the second magnetic element, and the second magnetic element moves toward the bottom along the central shaft body and impacts on the stop plate provided on the central shaft body to produce a tactile feel during downward pressing; and the magnitudes of the forward energizing current and reverse energizing current passing through the coil can be adjusted to change the magnitude of the magnetic force between the second magnetic element and the third magnetic element, so as to change the impact force to produce different tactile feels and downward pressing forces.

In the above description, in a more preferred solution, the housing is provided therein with two spring elements, and weld legs are provided on the bottom of the housing, with the weld legs corresponding to the spring elements in number and position.

In the above description, in a more preferred solution, the first magnetic element is a soft magnet element, the second magnetic element is a magnet, and the third magnetic element is an energizable coil.

In the above description, in a more preferred solution, the first magnetic element is an electromagnet, the second magnetic element is a magnet, and the third magnetic element is an energizable coil.

In the above description, in a more preferred solution, the first magnetic element is a soft magnet element, the second magnetic element is a magnet, and the third magnetic element is an electromagnet.

In the above description, in a more preferred solution, the first magnetic element is an electromagnet, the second magnetic element is a magnet, and the third magnetic element is an electromagnet.

In the above description, in a more preferred solution, the first magnetic element is a coil, the second magnetic element is a magnet, and the third magnetic element is an electromagnet.

In a preferable derivative embodiment of the present disclosure, the third magnetic material is moved to the bottom of the housing, and a magnetic sensor is added at the bottom of this product, so that a magnetic conductive key with a tactile feel can be implemented. Although the tactile intensity cannot be changed, this structure is simple, waterproof and dustproof, and has a super long service life.

The present disclosure achieves the following advantageous effects: a repulsive or attractive magnetic force is generated between the first magnetic element and the second magnetic element, an element forming an energizable coil is designed, and the magnitude of the repulsive or attractive magnetic force can be adjusted by changing the magnitude of an energizing current passing through the energizable coil, such that the feel is improved when pressing the keycap seat; the magnitudes of the forward energizing current and reverse energizing current passing through the coil can be adjusted to adjust the magnitude of the magnetic force between the second magnetic element and the third magnetic element, so as to change the tactile intensity and the downward pressing force; and a relatively strong tactile feel accompanied by a clicky feel can be achieved by adjusting the magnetic forces of the first magnetic element and the second magnetic element.

### Brief Description of Drawings

FIG. 1 is a schematic structural perspective view of a first embodiment of the present disclosure;
FIG. 2 is a sectional view of the first embodiment of the present disclosure; and
FIG. 3 is an exploded view of the first embodiment of the present disclosure.

In the figures, 1 indicates a housing, 2 indicates a central shaft body, 3 indicates a keycap seat, 4 indicates a stop plate, 5 indicates a first magnetic element, 6 indicates a second magnetic element, 7 indicates a return spring, 8 indicates a third magnetic element, 9 indicates an spring element, and 10 indicates a weld leg.

### Detailed Description of Embodiments

The present disclosure will be described in further detail below with reference to the accompanying drawings and specific embodiments.

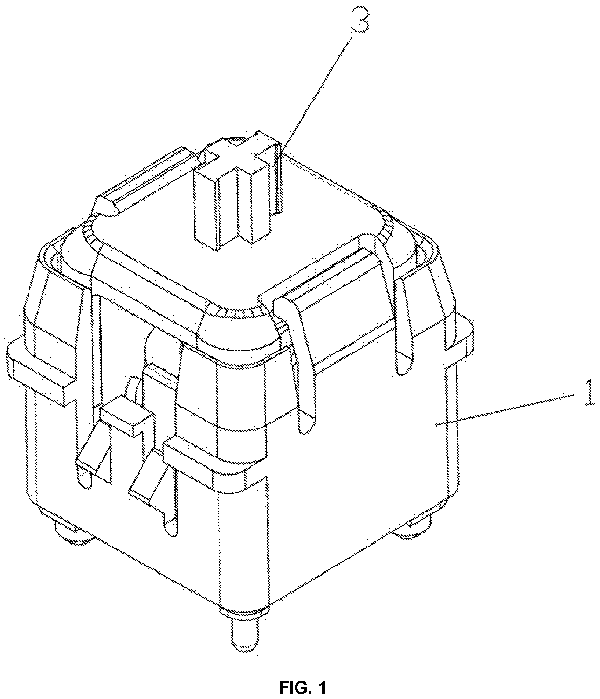

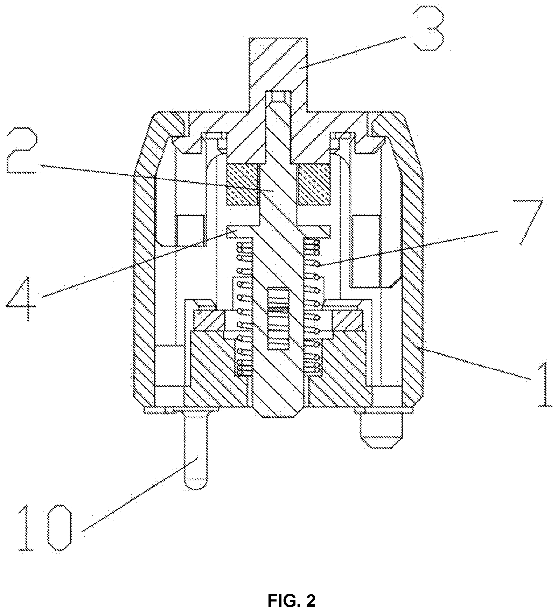

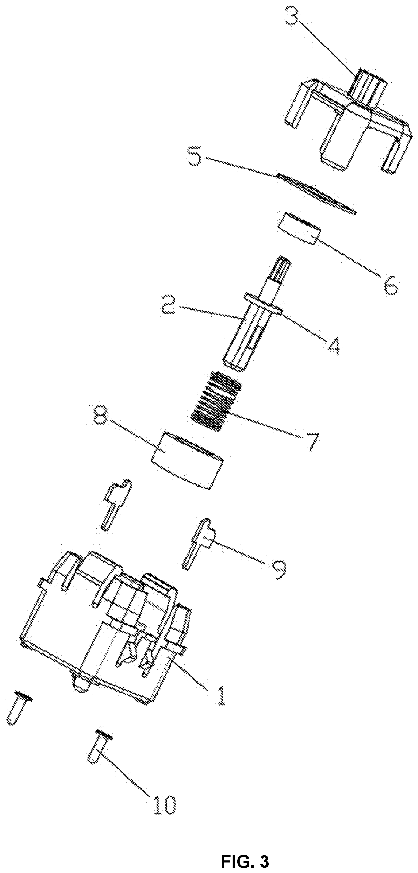

The embodiments will be described with reference to FIGS. 1 to 3.

### First Embodiment

Referring to and as shown in FIGS. 1 to 3, this embodiment comprises a housing 1 and a central shaft body 2 provided in the housing 1. A keycap seat 3 is provided on the top of the central shaft body 2. The bottom of the central shaft body 2 extends into the housing 1. When the keycap seat 3 is pressed, the central shaft body 2 can be reciprocated in a base along a vertical direction. The central shaft body 2 is provided thereon with a stop plate 4 partitioning the central shaft body 2 into two sections. A first magnetic element 5 is provided on the upper section of the central shaft body 2. A second magnetic element 6 movable up and down is provided coaxially with and below the first magnetic element 5. A return spring 7 is provided on the lower section of the central shaft body 2. A third magnetic element 8 is provided in the housing 1. The third magnetic element 8 is an energizable (or energizing) coil able of being energized with adjustable current.

When the energizable coil is not energized or is energized in a reverse direction, a magnetic force is generated between the first magnetic element and the second magnetic element or a repulsive force is generated between the second magnetic element 6 and the third magnetic element 8, such that the second magnetic element 6 is held on the upper section of the central shaft body 2. When the energizable coil is energized in a forward direction, a magnetic force is generated between the second magnetic element and the third magnetic element and is greater than the magnetic force between the first magnetic element 5 and the second magnetic element 6, and the second magnetic element 6 moves toward the bottom along the central shaft body 2 and impacts on the stop plate provided on the central shaft body 2 to produce a tactile feel during downward pressing. The magnitudes of the forward energizing current and reverse energizing current passing through the coil can be adjusted to adjust the magnitude of the magnetic force between the second magnetic element and the third magnetic element so as to change the tactile intensity and the downward pressing force.

The housing 1 of this embodiment is provided with two spring elements 9, and weld legs 10 are provided on the bottom of the housing 1, with the weld legs corresponding to the spring elements 9 in number and position.

The first magnetic element is a soft magnet element, the second magnetic element is a magnet, and the third magnetic element is a coil.

### Second Embodiment

A magnetic key of this embodiment is different from that of the first embodiment in that the first magnetic element is an electromagnet, the second magnetic element is a magnet, and the third magnetic element is a coil.

### Third Embodiment

A magnetic key of this embodiment is different from that of the first embodiment in that the first magnetic element is a soft magnet element, the second magnetic element is a magnet, and the third magnetic element is an electromagnet.

### Fourth Embodiment

A magnetic key of this embodiment is different from that of the first embodiment in that the first magnetic element is an electromagnet, the second magnetic element is a magnet, and the third magnetic element is an electromagnet.

### Fifth Embodiment

A magnetic key of this embodiment is different from that of the first embodiment in that the first magnetic element is a coil, the second magnetic element is a magnet, and the third magnetic element is an electromagnet.

The present disclosure has been described above in further detail in connection with the specific preferred embodiments, and it should not be considered that the specific implementation of the present disclosure is limited to these descriptions. It will be understood by those of ordinary skill in the art to which the present disclosure pertains that several simple deductions or alternatives can be made without departing from the concept of the present disclosure and should be considered to fall within the scope of protection of the present disclosure, as defined by the appended claims.

## Claims

1. A magnetic key, comprising a housing (1) and a central shaft body (2) provided in the housing (1), wherein a keycap seat (3) is provided on a top of the central shaft body, a bottom of the central shaft body (2) extends into the housing (1), and the central shaft body (2) is configured to be reciprocated in a base along a vertical direction when the keycap seat (3) is pressed,
wherein the central shaft body (2) is provided thereon with a stop plate (4) configured for partitioning the central shaft body (2) into two sections, which are upper and lower sections, wherein a first magnetic element (5) is provided on the upper section of the central shaft body (2), a second magnetic element (6) configured to be movable up and down is provided coaxially with and below the first magnetic element (5), the second magnetic element (6) is provided on the upper section of the central shaft body (2), a return spring (7) is provided on the lower section of the central shaft body (2), a third magnetic element (8) is provided in the housing (1), and the third magnetic element (8) is an energizable coil able of being energized with adjustable current or an electromagnet.

2. The magnetic key according to claim 1, wherein when the energizable coil is not energized or is energized in a reverse direction, a magnetic force is generated between the first magnetic element (5) and the second magnetic element (6), or a repulsive force is generated between the second magnetic element (6) and the third magnetic element (8), such that the second magnetic element (6) is held on the upper section of the central shaft body (2);
when the energizable coil is energized in a forward direction, a magnetic force is generated between the second magnetic element (6) and the third magnetic element (8) and is greater than the magnetic force between the first magnetic element (5) and the second magnetic element (6), and the second magnetic element (6) moves toward the bottom along the central shaft body (2) and impacts the stop plate (4) provided on the central shaft body (2) to produce a tactile feel during downward pressing; and
forward energizing current and reverse energizing current passing through the coil are able to be adjusted to change the magnetic force between the second magnetic element (6) and the third magnetic element (8), so as to change tactile intensity and downward pressing force.

3. The magnetic key according to claim 1 or 2, wherein the housing (1) is provided with two spring elements (9), and weld legs (10) are provided on a bottom of the housing (1), with the weld legs (10) corresponding to the spring elements (9) in number and position.

4. The magnetic key according to any one of claims 1 to 3, wherein the first magnetic element (5) is a soft magnet element, the second magnetic element (6) is a magnet, and the third magnetic element (8) is an energizable coil.

5. The magnetic key according to any one of claims 1 to 3, wherein the first magnetic element (5) is an electromagnet, the second magnetic element (6) is a magnet, and the third magnetic element (8) is an energizable coil.

6. The magnetic key according to any one of claims 1 to 3, wherein the first magnetic element (5) is a soft magnet element, the second magnetic element (6) is a magnet, and the third magnetic element (8) is an electromagnet.

7. The magnetic key according to any one of claims 1 to 3, wherein the first magnetic element (5) is an electromagnet, the second magnetic element (6) is a magnet, and the third magnetic element (8) is an electromagnet.

8. The magnetic key according to any one of claims 1 to 3, wherein the first magnetic element (5) is a coil, the second magnetic element (6) is a magnet, and the third magnetic element (8) is an electromagnet.

## Patentansprüche

1. Magnetische Taste, die ein Gehäuse (1) und einen mittigen Schaftkörper (2), der in dem Gehäuse (1) angeordnet ist, umfasst, wobei ein Tastenkappensitz (3) auf einer Oberseite des mittigen Schaftkörpers angeordnet ist, ein Boden des mittigen Schaftkörpers (2) sich in das Gehäuse (1) hinein erstreckt, und der mittige Schaftkörper (2) so konfiguriert ist, dass er in einer Basis entlang einer vertikalen Richtung hinund herbewegt wird, wenn der Tastenkappensitz (3) gedrückt wird,
wobei auf dem mittigen Schaftkörper (2) eine Endanschlagplatte (4) angeordnet ist, die so konfiguriert ist, dass sie den mittigen Schaftkörper (2) in zwei Abschnitte unterteilt, und zwar einen oberen und einen unteren Abschnitt, wobei ein erstes magnetisches Element (5) auf dem oberen Abschnitt des mittigen Schaftkörpers (2) angeordnet ist, ein zweites magnetisches Element (6), das so konfiguriert ist, dass es nach oben und unten bewegt werden kann, koaxial zu dem - und unter dem - ersten magnetischen Element (5) angeordnet ist, das zweite Magnetelement (6) am oberen Abschnitt des mittigen Schaftkörpers (2) angeordnet ist, eine Rückstellfeder (7) am unteren Abschnitt des mittigen Schaftkörpers (2) angeordnet ist, ein drittes Magnetelement (8) in dem Gehäuse (1) angeordnet ist, und das dritte Magnetelement (8) eine erregbare Spule, die mit einem verstellbaren Strom erregt werden kann, oder ein Elektromagnet ist.

2. Magnetische Taste nach Anspruch 1, wobei, wenn die erregbare Spule nicht erregt wird, oder in umgekehrter Richtung erregt wird, eine magnetische Kraft zwischen dem ersten magnetischen Element (5) und dem zweiten magnetischen Element (6) erzeugt wird oder eine abstoßende Kraft zwischen dem zweiten magnetischen Element (6) und dem dritten magnetischen Element (8) erzeugt wird, dergestalt, dass das zweite magnetische Element (6) auf dem oberen Abschnitt des mittigen Schaftkörpers (2) gehalten wird;
wenn die erregbare Spule in einer Vorwärtsrichtung erregt wird, eine magnetische Kraft zwischen dem zweiten magnetischen Element (6) und dem dritten magnetischen Element (8) erzeugt wird, die größer ist als die magnetische Kraft zwischen dem ersten magnetischen Element (5) und dem zweiten magnetischen Element (6), und das zweite magnetische Element (6) sich entlang des mittigen Schaftkörpers (2) nach unten bewegt und auf die Endanschlagplatte (4) trifft, die auf dem mittigen Schaftkörper (2) angeordnet ist, um ein taktiles Gefühl während des Abwärtsdrückens zu erzeugen; und
der Vorwärtserregungsstrom und der Rückwärtserregungsstrom, die durch die Spule fließen, verstellt werden können, um die Magnetkraft zwischen dem zweiten magnetischen Element (6) und dem dritten magnetischen Element (8) zu verändern, um die taktile Intensität und die Abwärtsdrückkraft zu verändern.

3. Magnetische Taste nach Anspruch 1 oder 2, wobei das Gehäuse (1) mit zwei Federelementen (9) versehen ist und an einer Unterseite des Gehäuses (1) Schweißstifte (10) angeordnet sind, wobei die Schweißstifte (10) in Anzahl und Position den Federelementen (9) entsprechen.

4. Magnetische Taste nach einem der Ansprüche 1 bis 3, wobei das erste magnetische Element (5) ein Weichmagnetelement ist, das zweite magnetische Element (6) ein Magnet ist, und das dritte magnetische Element (8) eine erregbare Spule ist.

5. Magnetische Taste nach einem der Ansprüche 1 bis 3, wobei das erste magnetische Element (5) ein Elektromagnet ist, das zweite magnetische Element (6) ein Magnet ist, und das dritte magnetische Element (8) eine erregbare Spule ist.

6. Magnetische Taste nach einem der Ansprüche 1 bis 3, wobei das erste magnetische Element (5) ein Weichmagnetelement ist, das zweite magnetische Element (6) ein Magnet ist, und das dritte magnetische Element (8) ein Elektromagnet ist.

7. Magnetische Taste nach einem der Ansprüche 1 bis 3, wobei das erste magnetische Element (5) ein Elektromagnet ist, das zweite magnetische Element (6) ein Magnet ist, und das dritte magnetische Element (8) ein Elektromagnet ist.

8. Magnetische Taste nach einem der Ansprüche 1 bis 3, wobei das erste magnetische Element (5) eine Spule ist, das zweite magnetische Element (6) ein Magnet ist, und das dritte magnetische Element (8) ein Elektromagnet ist.

## Revendications

1. Touche magnétique, comprenant un boîtier (1) et un corps d'arbre central (2) prévu dans le boîtier (1), dans laquelle un siège de dessus de touche (3) est prévu sur un sommet du corps d'arbre central, un fond du corps d'arbre central (2) s'étend dans le boîtier (1), et le corps d'arbre central (2) est configuré pour se déplacer en va-et-vient dans une base le long d'une direction verticale lorsque le siège de dessus de touche (3) est pressé,
dans laquelle le corps d'arbre central (2) est pourvu, sur celui-ci, d'une plaque de butée (4) configurée pour séparer le corps d'arbre central (2) en deux sections, qui sont une section supérieure et une section inférieure, dans laquelle un premier élément magnétique (5) est prévu sur la section supérieure du corps d'arbre central (2), un deuxième élément magnétique (6) configuré pour être mobile vers le haut et vers le bas est prévu coaxialement avec le premier élément magnétique (5) et au-dessous de celui-ci, le deuxième élément magnétique (6) est prévu sur la section supérieure du corps d'arbre central (2), un ressort de rappel (7) est prévu sur la section inférieure du corps d'arbre central (2), un troisième élément magnétique (8) est prévu dans le boîtier (1), et le troisième élément magnétique (8) est une bobine excitable apte à être excitée avec un courant ajustable ou un électroaimant.

2. Touche magnétique selon la revendication 1, dans laquelle, lorsque la bobine excitable n'est pas excitée ou est excitée dans une direction retour, une force magnétique est générée entre le premier élément magnétique (5) et le deuxième élément magnétique (6), ou une force de répulsion est générée entre le deuxième élément magnétique (6) et le troisième élément magnétique (8), de sorte que le deuxième élément magnétique (6) soit maintenu sur la section supérieure du corps d'arbre central (2) ;
lorsque la bobine excitable est excitée dans une direction aller, une force magnétique est générée entre le deuxième élément magnétique (6) et le troisième élément magnétique (8) et est supérieure à la force magnétique entre le premier élément magnétique (5) et le deuxième élément magnétique (6), et le deuxième élément magnétique (6) se déplace vers le fond le long du corps d'arbre central (2) et tape contre la plaque de butée (4) prévue sur le corps d'arbre central (2) pour produire une sensation tactile au cours d'une pression vers le bas ; et
le courant d'excitation aller et le courant d'excitation retour traversant la bobine sont aptes à être ajustés pour changer la force magnétique entre le deuxième élément magnétique (6) et le troisième élément magnétique (8), de manière à changer une intensité tactile et une force de pression vers le bas.

3. Touche magnétique selon la revendication 1 ou 2, dans laquelle le boîtier (1) est pourvu de deux éléments de ressort (9), et des pattes de soudure (10) sont prévues sur un fond du boîtier (1), avec les pattes de soudure (10) correspondant aux éléments de ressort (9) en nombre et en position.

4. Touche magnétique selon l'une quelconque des revendications 1 à 3, dans laquelle le premier élément magnétique (5) est un élément d'aimant doux, le deuxième élément magnétique (6) est un aimant, et le troisième élément magnétique (8) est une bobine excitable.

5. Touche magnétique selon l'une quelconque des revendications 1 à 3, dans laquelle le premier élément magnétique (5) est un électroaimant, le deuxième élément magnétique (6) est un aimant, et le troisième élément magnétique (8) est une bobine excitable.

6. Touche magnétique selon l'une quelconque des revendications 1 à 3, dans laquelle le premier élément magnétique (5) est un élément d'aimant doux, le deuxième élément magnétique (6) est un aimant, et le troisième élément magnétique (8) est un électroaimant.

7. Touche magnétique selon l'une quelconque des revendications 1 à 3, dans laquelle le premier élément magnétique (5) est un électroaimant, le deuxième élément magnétique (6) est un aimant, et le troisième élément magnétique (8) est un électroaimant.

8. Touche magnétique selon l'une quelconque des revendications 1 à 3, dans laquelle le premier élément magnétique (5) est une bobine, le deuxième élément magnétique (6) est un aimant, et le troisième élément magnétique (8) est un électroaimant.
